# EUROPEAN PATENT SPECIFICATION

(11) **EP 3 350 914 B1**
(45) Date of publication and mention of the grant of the patent: **07.04.2021**
(21) Application number: 16847338.7
(22) Date of filing: 15.09.2016
(51) Int. Cl.: H02M 3/158, H03K 17/60, H01L 29/747, H01L 29/66, H01L 29/732, H01L 29/10, H03K 17/0412, H03K 17/567

(54) **OPERATION OF DOUBLE-BASE BIPOLAR TRANSISTORS WITH ADDITIONAL TIMING PHASES AT SWITCHING TRANSITIONS**
BETRIEB VON ZWEIPOLIGEN DOPPELPHASEN-TRANSISTOREN MIT ZUSÄTZLICHEN TAKTUNGSPHASEN AN SCHALTUNGSÜBERGÄNGEN
FONCTIONNEMENT DE TRANSISTORS BIPOLAIRES À DOUBLE BASE AVEC PHASES DE TEMPORISATION SUPPLÉMENTAIRES AU NIVEAU DES TRANSITIONS DE COMMUTATION

(30) Priority: 15.09.2015 US 201562218978 P; 09.10.2015 US 201562239815 P
(43) Date of publication of application: 25.07.2018
(73) Proprietor: Ideal Power Inc., Austin, TX 78744 (US)
(72) Inventor: ALEXANDER, William C., Spicewood, Texas 78669 (US); BLANCHARD, Richard A., Los Altos, California 94024 (US)
(74) Representative: Pitchford, James Edward
(86) International application number: PCT/US2016/052008
(87) International publication number: WO 2017/049006

(56) References cited:
- WO-A1-01/28095
- GB-A- 2 510 716
- JP-A- 2008 300 590
- US-A1- 2006 007 717
- US-A1- 2014 198 533
- US-A1- 2014 375 287
- US-A1- 2015 054 552
- Ideal Power: "B-TRAN - Bi-Directional Bi-Polar Junction TRANsistor", , 30 April 2016 (2016-04-30), pages 1-11, XP055494264, 4120 Freidrich Lane, Ste. 100 Austin, Texas 78744 Retrieved from the Internet: URL:http://www.idealpower.com/wp-content/u ploads/2018/02/WHT-00002_RevC_BTRAN_April2 016.pdf [retrieved on 2018-07-20]

## Description

### BACKGROUND

The present application relates to double-base bipolar transistors and circuits and systems including them, and to methods for operating such transistors and circuits and systems.

Note that the points discussed below may reflect the hindsight gained from the present disclosure, and are not necessarily admitted to be prior art.

US Application 14/313,960 (now issued as US 9,029,909 B2) disclosed bidirectional bipolar transistors known as "B-TRANs," and methods for operating such transistors. Further improvements, applications, and implementations were disclosed in subsequent commonly-owned and copending patent applications, including e.g. US 2016/0141375 A1, US 2016/0173083 A1, WO 2016/112395 A1, and US 2016/0241232 A1.

The most basic B-TRAN is a four-terminal three-layer power device. In the most basic version, each side of a p-type monolithic semiconductor wafer has an n-type emitter/collector region and a p-type base contact region. The two base regions are contacted separately, and the two emitter/collector regions are connected to provide the two current-carrying terminals. This example can operate, in either direction of current flow, as an NPN bipolar transistor.

The polarity of the externally applied voltage will determine which of the emitter/collector regions is operating as the emitter (i.e. is emitting electrons, in this NPN example), and which is operating as the collector. The two base regions are not connected together, but are operated separately: in describing the operation of this class of devices, the base region on the same surface as the collector will normally be referred to as the "c-base," and the base region on the same surface as the emitter will normally be referred to as the "e-base." (Of course, when the external polarity reverses, the functions of the two emitter/collector regions will be exchanged: the collector will become the emitter, the emitter will become the collector, the e-base will become the c-base, and the c-base will become the e-base.)

The methods of operation described in the US 9,029,909 patent, and in the published applications listed above, result in a fully bidirectional switching device which provides high gain, high breakdown voltage, and low voltage drop in the ON state. This combination of advantages is extremely advantageous.

To achieve this combination of advantages, an operation sequence was disclosed which included a pre-turnoff timing phase as well as a preliminary turn-on phase (known as "diode turn-on"). The principles of operation are very different from those of conventional bipolar power transistors, as may be seen from the following description.

A B-TRAN is in the "active off-state" when the e-base (base on the emitter side) is shorted to the emitter, and the c-base (base on the collector side) is open. In this state, with the NPN B-TRAN, the collector is the anode (high voltage side), and the emitter is the cathode (low voltage side).

The B-TRAN is also off when both bases are open, but due to the high gain of the B-TRAN in this state, the breakdown voltage is low. The series combination of a normally-ON JFET and a Schottky diode attached between each base on its respective emitter/collector, as previously disclosed, will significantly increase the blocking voltage in this "passive off-state". The JFETs are turned off during normal operation.

The e-base is essentially at a constant voltage - it varies only about 0.1 V from a low drive to a high drive condition. The c-base, in contrast, is a nearly constant current drive, even as the voltage is varied from 0 V above the collector to about 0.6 V. Instead of the c-base current changing with c-base voltage, Vce changes. At a c-base voltage of 0 V (c-base shorted to collector), there is a certain gain that depends on the emitter current density, and Vce is nominally 0.9 V over a large range of current density. Raising the c-base to 0.1 V above the collector does not change the gain, but it lowers Vce by nominally 0.1 V. Raising the c-base to 0.6V drops Vce to about 0.2 or 0.3 V.

One sample embodiment for B-TRAN turn-on is to simultaneously, from the active off-state and blocking forward voltage, open the e-base-to-emitter short while shorting the c-base to the collector. This immediately introduces charge carriers into the highest field region of the depletion zone around the collector/base junction, so as to achieve very fast, forward biased turn-on for hard switching, very similar to IGBT turn-on.

Another advantageous turn-on method, from the active off-state, is to have the circuit containing the B-TRAN reverse the B-TRAN polarity, which produces the same base state described in the hard turn-on method, but at near zero voltage. That is, the e-base which is shorted to the emitter becomes the c-base shorted to the collector as the B-TRAN voltage reverses from the active off-state polarity. Again, turn-on is fast.

In a third turn-on method from the active off-state, the e-base is disconnected from the emitter, and connected to a current or voltage source of sufficient voltage to inject charge carriers into the base region. This method is likely slower, since the charge carriers go into the base just below the depletion zone. Also, it is known that carrier injection into the e-base results in inferior gain relative to carrier injection into the c-base.

After turn-on is achieved with either of the methods using the c-base, Vce is more than a diode drop. To drive Vce below a diode drop, turn-on goes to the second stage of increased charge injection into the c-base via a voltage or current source. The amount of increased charge injection determines how much Vce is reduced below a diode drop. Injection into the e-base will also reduce Vce, but the gain is much lower than with c-base injection.

In the first step of one advantageous turn-off method, the c-base is disconnected from the carrier injection power supply and shorted to the collector, while the previously open e-base is shorted to the emitter. This results in a large current flow between each base and its emitter/collector, which rapidly removes charge carriers from the drift region. This in turn results in a rising Vce as the effective resistivity of the drift region increases. At some optimum time after the bases are shorted, the connection between the c-base and the collector is opened, after which Vce increases rapidly as the depletion region forms around the collector/base junction.

Turn-off can be achieved by simply opening the c-base and shorting the e-base to the emitter, but this will result in higher turn-off losses since the drift region (base) will have a high level of charge carriers at the start of depletion zone formation.

Turn-off can also be achieved by simply opening the c-base and leaving the e-base open, but this will result in the highest turn-off losses and also a low breakdown voltage.

Further background art is provided in US 2014/375287 A1, which discloses methods, systems, circuits, and devices for power-packet-switching power converters using bidirectional bipolar transistors (B-TRANs) for switching.

### Operation of Double-Base Bipolar Transistors with Additional Timing Phases at Switching Transitions

The present invention is a method as defined in Claim 1 of the appended claims, for operating a bidirectional bipolar power transistor. Also provided is a base driving circuit which is connected to a double-base bidirectional bipolar power transistor, as defined in Claim 8.

The present application teaches, among other innovations, new improvements to methods of operating a B-TRAN-type device, and new circuits which perform these improved methods. The present application also teaches, among other innovations, circuits and systems which incorporate a device with improved operation as above, and methods for operating such circuits and systems. A particularly beneficial feature is the introduction of an additional pre-turnoff timing phase, as described below. This additional timing phase reduces the minority carrier population, resulting in faster quenching of bipolar conduction.

In one example of an NPN B-TRAN device, turn-off begins with a pre-turnoff stage as before, where each base contact region is shorted to its adjacent emitter/collector region. However, according to the additional disclosure in the present application, this first pre-turnoff stage is followed by a second pre-turnoff timing phase, where negative drive is applied to the e-base (i.e. to the base contact region on the same side as the emitter, which is the more negative of the two emitter/collector regions). This negative drive reduces the population of holes in the bulk base, also referred to as bulk substrate, (which is the p-type bulk of the semiconductor material). Since the population of holes is reduced, secondary emission of electrons from the collector junction is also necessarily reduced, and the nonequilibrium ON-state carrier concentration moves toward its equilibrium value. (The nonequilibrium carrier concentration can be orders of magnitude greater than its equilibrium value.)

Some of the disclosed base drive circuits provide this second pre-turnoff timing phase very easily, since the base drive circuits disclosed in previous applications already included elements which provided the voltage offset which is exploited here to provide negative base drive (for an NPN device; of course, polarities are reversed in a PNP device).

The innovative teachings provide the benefit, among others, of faster turn-off, and correspondingly less energy loss, in double-base bipolar transistors.

The innovative teachings also provide more efficient switching of phase legs (and analogous configurations). When two transistors are connected in series between two supply lines, the transistor which is turning off (during switching) will turn off faster during its reverse recovery: this reduces the current which would pass through the other transistor of the phase leg while it is turning on.

Further inventive features and advantages are set forth in the following description.

### BRIEF DESCRIPTION OF THE DRAWINGS

The present invention will be described with reference to the accompanying drawings, which show important sample embodiments and which are incorporated in the specification hereof by reference, wherein:
**Figure 1** shows waveform plots for one sample embodiment of turn-off switching using e.g. a base drive circuit like that of Figure 2.
**Figure 2** shows a sample B-TRAN base drive with two negative e-base drive modules (one for either base contact region).
**Figure 3** shows another negative base drive circuit which can operate a B-TRAN.
**Figure 4** shows waveform plots for one sample embodiment of reverse recovery switching using a negative base drive.
**Figure 5** shows another negative base drive circuit which operates a B-TRAN.
**Figure 6** shows an example of a B-TRAN device structure.
**Figure 7** shows a phase leg configuration which is discussed for illustration of the Schottky diode's function.

### DETAILED DESCRIPTION OF SAMPLE EMBODIMENTS

Presently preferred embodiments of the present invention will be described by way of example, and not of limitation. None of the statements below should be taken as limiting the claims generally.

The present application teaches that B-TRANs can advantageously be driven using negative base drive circuits like those seen in the sample embodiments, and their equivalents. For an NPN B-TRAN, the negative base drive is applied to the "e-base" (i.e. the base contact region on the emitter side, where the more negative external voltage appears), and draws holes out of the p-type bulk base.

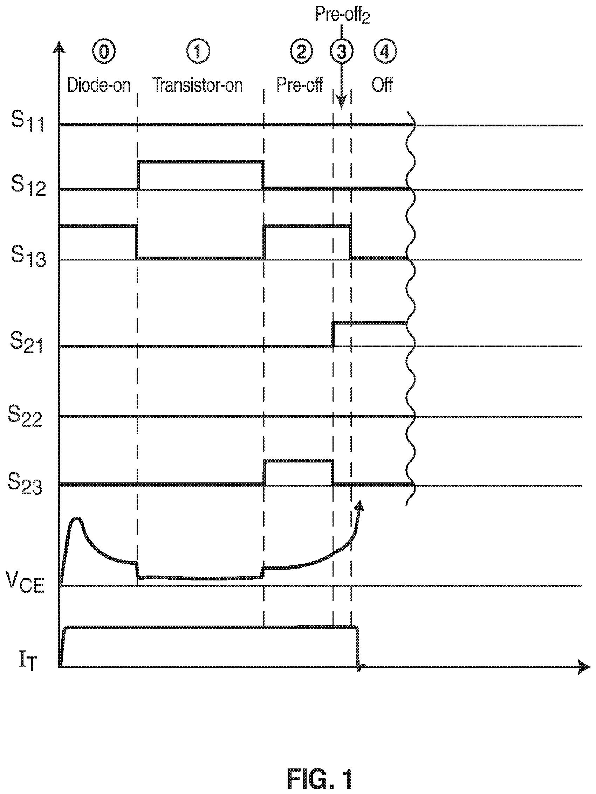

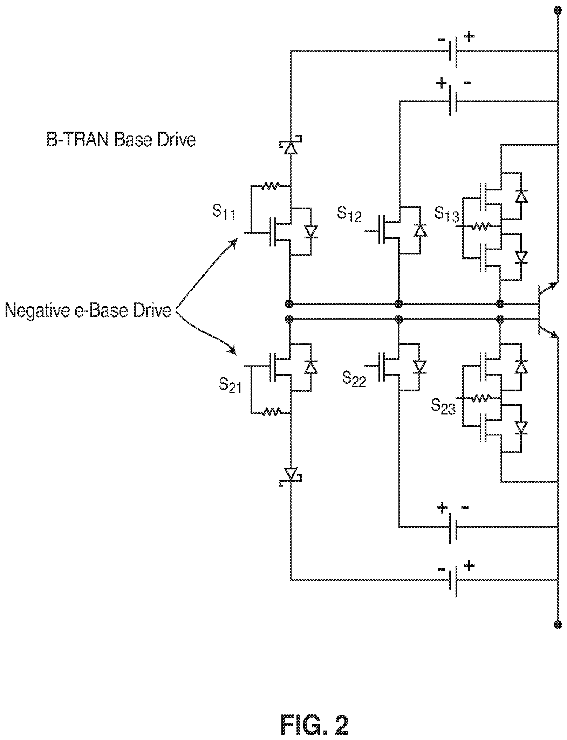

**Figure 2** shows an example of a base drive circuit connected to a B-TRAN. (Typically the B-TRAN will be a discrete power device.) Note generally that three circuit legs are connected to each of the two base contacts of the B-TRAN. One leg (switch **S₁₃** or switch **S₂₃**) uses back-to-back devices to provide bidirectional conduction, but does not include an added voltage offset. This leg provides the connections for the "diode-on" mode (timing **phase 1** of Figure 1) and for the first pre-off stage (timing **phase 3** of Figure 1).

The other two legs include voltage offsets, as described in the previous applications referenced above. Note that the body diode of switch **S₂₁** is opposite to that of switch **S₂₂,** and the voltage offsets in series with these two switches have different polarities. (Similarly, **S₁₁** and **S₁₂** are oppositely configured.) One Schottky diode is connected in series with S₂₁, and another with **S₁₁.**

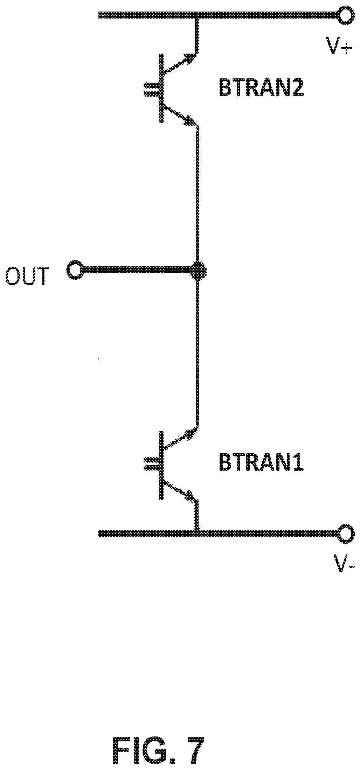

The function of the Schottky diode is as follows. The circuit of **Figure 7** shows a simple circuit configuration for illustration: Suppose that two NPN B-TRAN devices, **BTRAN1** and **BTRAN2,** are connected in series between two supply rails **V+** and **V-** to form a phase leg with an output node **OUT.** In such a configuration, only one of the B-TRAN devices is allowed to be fully ON at any given instant. Assume that BTRAN1 is connected between the output node and whichever rail is negative (at the moment), and BTRAN2 is connected between the output node and whichever rail is positive (at the moment). Now consider the transition when the phase leg is switched, so that the OUT node is to be pulled up rather than pulled down.

The pulldown device BTRAN1 will turn off, and the pullup device BTRAN2 will turn on. This means that BTRAN1 will go into reverse recovery. Just prior to reverse recovery of a B-TRAN operating as a diode (BTRAN1), the device is prepared for reverse recovery by first shorting the e-base to the emitter for pre-off-1, then the e-base is connected to a voltage negative with respect to the emitter (negative e-base drive) in order to complete the removal of charge carriers from the bulk base region (during phase 4, pre-off-2), then due to turn-on of the other B-TRAN in the phase leg the current reverses in B-TRAN-1, whereupon the emitter changes to collector, and e-base changed to c-base, and that device starts blocking voltage from collector to emitter. This causes the c-base voltage to drop below the collector, and also below the negative e-base drive. The Schottky diode prevents current flow from the negative e-base drive to the c-base, which, if it happened, would prevent B-TRAN-1 from blocking voltage.

**Figure 1** shows waveform plots for one sample embodiment of turn-off switching using e.g. a base drive circuit like that of Figure 2. Note that, instead of the single pre-turnoff timing phase disclosed in previous applications, two pre-turnoff timing phases appear here. The two pre-turnoff timing phases are labeled as "**Pre-off₁**" (or **phase 2**) and **"Pre-off₂"** (or **phase 3**).

In the stage labeled "Pre-off₂", switch S₂₁ turns on, briefly driving the e-base negative just before turn-off (which occurs in **phase 5**). This reduces turn-off losses.

The first timing phase illustrated **(phase 0)** is the "diode-on" mode. Here switch S₁₃ is connecting the c-base to the collector. This results in conduction subject to a "diode drop" (about 0.9V for silicon) of forward bias.

The second timing phase illustrated **(phase 1)** is the "transistor-on" mode. Here switch S₁₂ is connecting the c-base to a positive voltage with respect to the collector. This results in conduction subject to a very small forward bias (e.g. 200mV or so of V_{CE}).

The third timing phase illustrated is the pre-turnoff timing phase "Pre-off₁" (or phase 2). In this timing phase both of the base contact regions are shorted to their adjacent emitter/collector regions.

The fourth timing phase illustrated is the second pre-turnoff timing phase "Pre-off₂" (or phase 3). In this timing phase the e-base is driven to reduce conduction; in a PNP device a negative drive is applied to the e-base, as described above.

The last timing phase illustrated is the "active-off' timing phase (phase 4). In this timing phase both of the base contact regions are shorted to their adjacent emitter/collector regions.

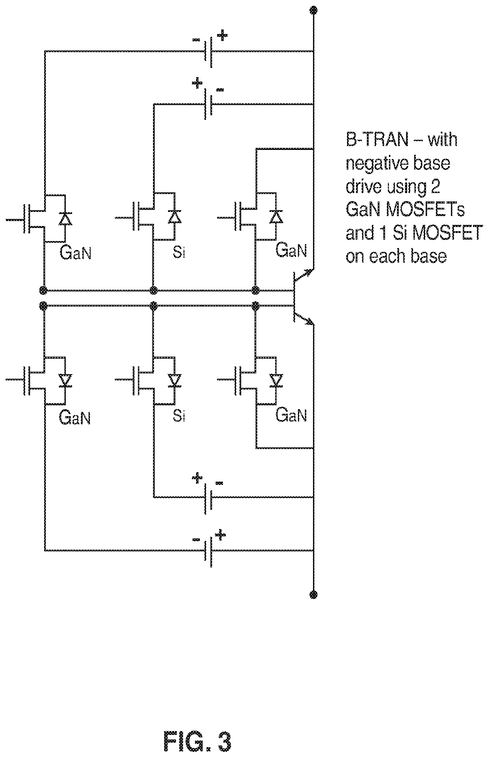

**Figure 3** shows another negative base drive circuit, which operates a B-TRAN (silicon in this example) using two GaN MOSFETs and one Si MOSFET on each base. Since the bandgap of GaN is higher than Si, the larger diode drop voltage (of the body diode) of the GaN MOSFETs provides a differential with respect to the body diodes of the silicon devices.

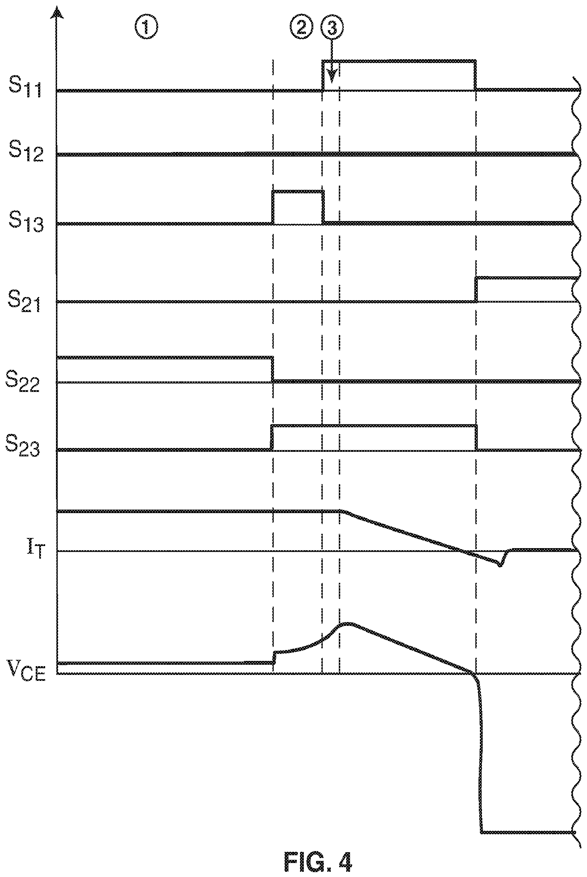

**Figure 4** shows waveform plots for one sample embodiment of reverse recovery switching for a negative base drive like e.g. that of Figure 2. Here, the negative base drive briefly pulls the e-base negative to reduce turn-on and reverse recovery losses.

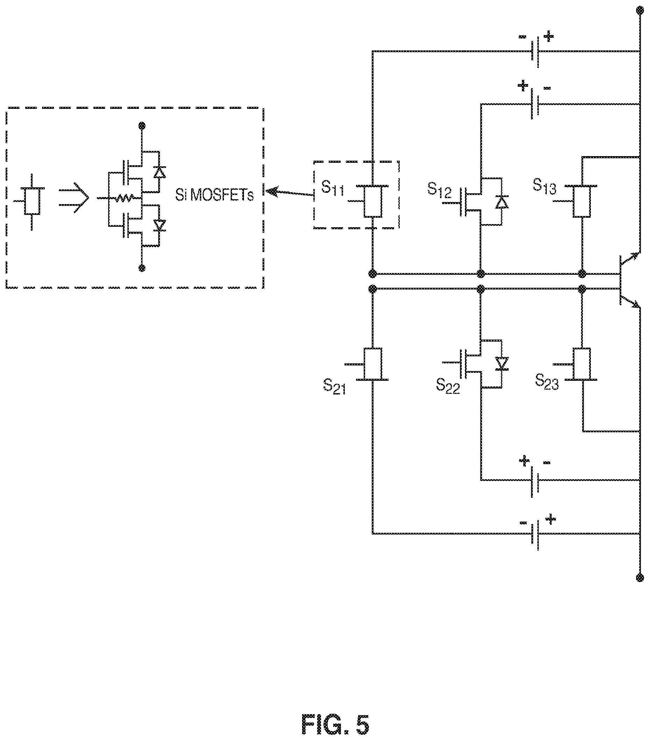

**Figure 5** shows another negative base drive circuit, which operates a B-TRAN using two Si MOSFET pairs and one Si MOSFET on each base.

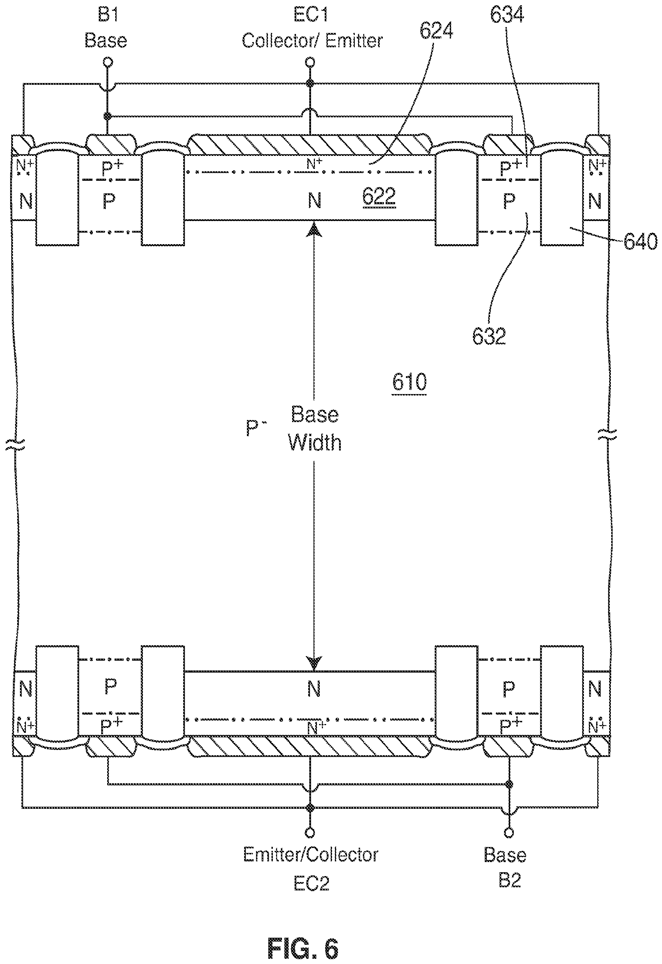

**Figure 6** shows an example of a B-TRAN device structure. In this Figure, both faces of a semiconductor die carry emitter/collector regions 622 which form a junction with the bulk substrate 610. Base contact regions 632 are also present on both faces. This example shows an NPN structure, so the emitter/collector regions 622 are n-type, and the base contact regions 632 are p-type. A shallow n+ contact doping 624 provides ohmic contact from separate terminals EC1 and EC2 (on the two opposite faces of the semiconductor die, in this example) to regions 622, and a shallow p+ contact doping 634 provides ohmic contact from separate terminals B1 and B2 (on the two opposite faces of the die) to regions 632. In this example, dielectric-filled trenches 640 provide lateral separation between base contact regions 632 and emitter/collector regions 622. (Note that a p-type diffused region may be added to reduce the series resistance between the emitter-to-base junction and the base contact.) B-TRANs can provide significantly better efficiency than is conventionally available for existing static transfer switches; for example, a 1200V B-TRAN has an expected system efficiency of 99.9%.

### Advantages

The disclosed innovations, in various embodiments, provide one or more of at least the following advantages. However, not all of these advantages result from every one of the innovations disclosed, and this list of advantages does not limit the scope of the appended claims.
- Faster reverse recovery;
- Faster turn-off;
- Reduced switching losses;
- Phase legs with reduced losses; and
- Improved efficiency in power conversion systems.

According to some but not necessarily all embodiments, there is provided: Methods and systems for operating a double-base bidirectional power bipolar transistor. Two timing phases are used to transition into turn-off: one where each base is shorted to its nearest emitter/collector region, and a second one where negative drive is applied to the emitter-side base to reduce the minority carrier population in the bulk substrate. A diode prevents reverse turn-on while negative base drive is being applied.

According to some but not necessarily all embodiments, there is provided: A method for operating a bidirectional bipolar power transistor which has two distinct n-type emitter/collector regions on opposite faces of a p-type semiconductor die, and two distinct p-type base contact regions on the opposite faces of the die, comprising: 1) in a transistor-ON timing phase, when minimal voltage drop is desired, biasing a first one of the base contact regions, which is closest to whichever of the emitter/collector regions is more positive at the moment, to a voltage which causes bipolar conduction, to thereby reduce the voltage drop between the two emitter/collector regions; and thereafter 2) in a first pre-turnoff timing phase, shorting each of the base contact regions to the respectively nearest one of the emitter/collector regions, to thereby increase the voltage drop between the two emitter/collector regions; and thereafter 3) in a second pre-turnoff timing phase, biasing the second base contact regions negative with respect to its nearest emitter/collector region, to thereby reduce the minority carrier concentration in the bulk base region.

According to some but not necessarily all embodiments, there is provided: A method for operating a bidirectional bipolar power transistor which has two distinct n-type emitter/collector regions on opposite faces of a p-type semiconductor die, and two distinct p-type base contact regions on the opposite faces of the die, comprising, when a first one of the emitter/collector regions is more positive than a second one of the emitter/collector regions: 0) in a diode-ON timing phase, shorting a first one of the base contact regions to the first emitter/collector region, which is the nearest thereto, to thereby initiate conduction between the two emitter/collector regions; and thereafter 1) in a transistor-ON timing phase, when minimal voltage drop is desired, biasing the first base contact region to a voltage which causes bipolar conduction, to thereby reduce the voltage drop between the two emitter/collector regions; and thereafter 2) in a first pre-turnoff timing phase, shorting each of the base contact regions to the respectively nearest one of the emitter/collector regions, to thereby increase the voltage drop between the two emitter/collector regions; and thereafter 3) in a second pre-turnoff timing phase, biasing the second base contact regions negative with respect to the second emitter/collector region; and thereafter 4) shorting the second base contact region to the second emitter/collector region, to keep the device turned off.

According to some but not necessarily all embodiments, there is provided: A method for operating a bidirectional bipolar transistor which has two first-conductivity-type emitter/collector regions in distinct locations separated by a bulk second-conductivity-type base region, and two distinct second-conductivity-type base contact regions which connect to the bulk base region in mutually separate locations, comprising: 1) in a transistor-ON timing phase, when minimal voltage drop is desired, biasing a first one of the base contact regions, which is closer than a second one of the base contact regions to whichever of the emitter/collector regions is positioned to act as the collector, as defined by externally applied voltage polarity, to a voltage which causes bipolar conduction to reduce the voltage drop between the two emitter/collector regions; and thereafter 2) in a first pre-turnoff timing phase, shorting each of the base contact regions to the respectively nearest one of the emitter/collector regions; and thereafter 3) in a second pre-turnoff timing phase, biasing the second base contact regions with a polarity opposite to that applied to the first base contact region in step 1), to thereby reduce the minority carrier concentration in the bulk base region; and thereafter 4) turning the device off.

According to some but not necessarily all embodiments, there is provided: A method for operating a bidirectional bipolar power transistor which has two distinct n-type emitter/collector regions on opposite faces of a p-type semiconductor die, and two distinct p-type base contact regions on the opposite faces of the die, comprising: 1) in a transistor-ON timing phase, when minimal voltage drop is desired, biasing a first one of the base contact regions, which is closest to whichever of the emitter/collector regions is more positive at the moment, to a voltage which causes bipolar conduction, to thereby reduce the voltage drop between the two emitter/collector regions; and thereafter 2) in a first pre-turnoff timing phase, shorting each of the base contact regions to the respectively nearest one of the emitter/collector regions, to thereby increase the voltage drop between the two emitter/collector regions; and thereafter 3) in a second pre-turnoff timing phase, biasing the second base contact regions negative with respect to its nearest emitter/collector region, to thereby reduce the minority carrier concentration in the bulk base region; and during step 3), using a diode to block current which would tend to turn on conduction in a direction opposite to that of step 1).

### Modifications and Variations

As will be recognized by those skilled in the art, the innovative concepts described in the present application can be modified and varied over a tremendous range of applications, and accordingly the scope of patented subject matter is not limited by any of the specific exemplary teachings given. It is intended to embrace all such alternatives, modifications and variations that fall within the scope of the appended claims, which define the present invention.

Note that the claimed inventions can also be applied other double-base bipolar conduction devices, such as the "MTRAN" described in WO 2016/064923 Al.

None of the description in the present application should be read as implying that any particular element, step, or function is an essential element which must be included in the claim scope: THE SCOPE OF PATENTED SUBJECT MATTER IS DEFINED ONLY BY THE ALLOWED CLAIMS.

The claims as filed are intended to be as comprehensive as possible, and NO subject matter is intentionally relinquished, dedicated, or abandoned.

## Claims

1. A method for operating a bidirectional bipolar power transistor which has two distinct first-conductivity-type emitter/collector regions (622) on opposite faces of a second-conductivity-type bulk substrate (610) of a semiconductor die, and two distinct second-conductivity-type base contact regions (632) on the opposite faces of the bulk substrate (610), the method comprising:
1) in a transistor-ON timing phase, when minimal voltage drop is desired, biasing a first one of the base contact regions (632), which is closest to whichever of the emitter/collector regions (622) is acting as a collector, as defined by externally applied voltage polarity, to a voltage which causes bipolar conduction, to thereby reduce the voltage drop between the two emitter/collector regions (622); and thereafter
2) in a first pre-turnoff timing phase, shorting each of the base contact regions (632) to the respectively nearest one of the emitter/collector regions (622), to thereby increase the voltage drop between the two emitter/collector regions (622); and thereafter **characterised by**
3) in a second pre-turnoff timing phase, biasing the second base contact region (632) with a polarity opposite to that applied to the first base contact region (632) in step 1), to thereby reduce the minority carrier concentration in the bulk substrate (610).

2. The method of claim 1, further comprising, before step 1):
0) in a diode-ON timing phase, shorting the first one of the base contact regions (632) to its nearest emitter/collector region (622), to thereby initiate conduction between the two emitter/collector regions (622);
and further comprising, after step 3):
4) shorting the second base contact region (632) to its nearest emitter/collector region (622), to keep the device turned off.

3. The method of claim 1, further comprising, after step 3):
4) turning the device off.

4. The method of claim 1, further comprising:
during step 3), using a diode to block current which would tend to turn on conduction in a direction opposite to that of step 1).

5. The method of any preceding claim, wherein the first conductivity type is n-type.

6. The method of any of claims 1 to 4, wherein step 3) has a shorter duration than step 2).

7. The method of any of claims 1 to 4, wherein the semiconductor die is silicon.

8. A base driving circuit which is connected to a double-base bidirectional bipolar power transistor,
wherein the bidirectional bipolar power transistor has two distinct first-conductivity-type emitter/collector regions (622) on opposite faces of a second-conductivity-type bulk substrate (610) of a semiconductor die, and two distinct second-conductivity-type base contact regions (632) on the opposite faces of the bulk substrate (610);
wherein the base driving circuit comprises three circuit legs (S₁₁, S₁₂, S₁₃; S₂₁, S₂₂, S₂₃) connected to each of the two base contact regions (632) of the bidirectional bipolar power transistor, wherein one circuit leg (S₁₃; S₂₃) is operable to provide bidirectional conduction, and the other circuit legs (S₁₁; S₂₁, S₁₂; S₂₂) are operable to provide voltage offsets of different polarities;
and wherein the base driving circuit is configured to implement the method of any of claims 1 to 4.

9. The base driving circuit of claim 8, which further includes a Schottky barrier diode which is connected to block turn-on of reverse conduction during periods of negative base drive.

## Patentansprüche

1. Verfahren zum Betreiben eines bidirektionalen bipolaren Leistungstransistors, der zwei unterschiedliche Erste-Leitfähigkeits-Typ-Emitter-/Kollektorregionen (622) auf entgegengesetzten Flächen eines Zweite-Leitfähigkeits-Typ-Volumensubstrats (610) eines Halbleiter-Dies und zwei unterschiedliche Zweite-Leitfähigkeits-Typ-Basiskontaktregionen (632) auf entgegengesetzten Flächen des Volumensubstrats (610) aufweist, wobei das Verfahren Folgendes umfasst:
1) in einer Transistor-EIN-Taktphase, wenn ein minimaler Spannungsabfall gewünscht ist, Vorspannen einer ersten der Basiskontaktregionen (632), die jener der Emitter-/Kollektorregionen (622) am nächsten ist, die als Kollektor fungiert, wie definiert durch eine extern angewandte Spannungspolarität, auf eine Spannung, die eine bipolare Leitung verursacht, um dadurch den Spannungsabfall zwischen den zwei Emitter-/Kollektorregionen (622) zu reduzieren; und
2) in einer ersten Vorabschaltungs-Taktphase, Kurzschließen jeder der Basiskontaktregionen (632) mit der jeweiligen nächstliegenden der Emitter-/Kollektorregionen (622), um dadurch den Spannungsabfall zwischen den zwei Emitter-/Kollektorregionen (622) zu erhöhen; danach **gekennzeichnet durch**
3) in einer zweiten Vorabschaltungs-Taktphase, Vorspannen der zweiten Basiskontaktregion (632) mit einer Polarität, die der auf die erste Basiskontaktregion (632) in Schritt 1) angewandte entgegengesetzt ist, um dadurch die Minoritätsträgerkonzentration in dem Volumensubstrat (610) zu reduzieren.

2. Verfahren nach Anspruch 1, das ferner, vor Schritt 1), Folgendes umfasst:
0) in einer Dioden-EIN-Taktphase, Kurzschließen der ersten der Basiskontaktregionen (632) mit ihrer nächstliegenden Emitter-/Kollektorregion (622), um dadurch eine Leitung zwischen den zwei Emitter-/Kollektorregionen (622) einzuleiten;
und ferner, nach Schritt 3), Folgendes umfasst:
4) Kurzschließen der zweiten Basiskontaktregion (632) mit ihrer nächstliegenden Emitter-/Kollektorregion (622), um die Vorrichtung ausgeschaltet zu halten.

3. Verfahren nach Anspruch 1, das ferner, nach Schritt 3), Folgendes umfasst:
4) Ausschalten der Vorrichtung.

4. Verfahren nach Schritt 1, das ferner Folgendes umfasst:
während Schritt 3), Verwenden einer Diode, um Strom zu blockieren, der dazu tendieren würde, eine Leitung in einer Richtung, die der von Schritt 1) entgegengesetzt ist, einzuschalten.

5. Verfahren nach einem vorhergehenden Anspruch, wobei der erste Leitfähigkeitstyp n-Typ ist.

6. Verfahren nach einem der Ansprüche 1 bis 4, wobei Schritt 3) eine kürzere Dauer als Schritt 2) aufweist.

7. Verfahren nach einem der Ansprüche 1 bis 4, wobei das Halbleiter-Die Silicium ist.

8. Basisansteuerungsschaltung, die mit einem bidirektionalen bipolaren Doppelbasis-Leistungstransistor verbunden ist,
wobei der bidirektionale bipolare Leistungstransistor zwei unterschiedliche Erste-Leitfähigkeits-Typ-Emitter-/Kollektorregionen (622) auf entgegengesetzten Flächen eines Zweite-Leitfähigkeits-Typ-Volumensubstrats (610) eines Halbleiter-Dies und zwei unterschiedliche Zweite-Leitfähigkeits-Typ-Basiskontaktregionen (632) auf entgegengesetzten Flächen des Volumensubstrats (610) aufweist;
wobei die Basisansteuerungsschaltung drei Schaltungsstränge (S11, S12, S13; S21, S22, S23) umfasst, die mit jeder der zwei Basiskontaktregionen (632) des bidirektionalen bipolaren Leistungstransistor verbunden sind, wobei ein Schaltungsstrang (S13; S23) wirksam ist, um eine bidirektionale Leitung bereitzustellen, und die anderen Schaltungsstränge (S11; S21, S12; S22) wirksam sind, um Spannungsoffsets mit verschiedenen Polaritäten bereitzustellen;
und wobei die Basisansteuerungsschaltung konfiguriert ist, das Verfahren nach einem der Ansprüche 1 bis 4 zu implementieren.

9. Basisansteuerungsschaltung nach Anspruch 8, die ferner eine Schottky-Barrierediode beinhaltet, die verbunden ist, um ein Einschalten einer Rückwärtsleitung während Perioden einer negativen Basisansteuerung zu blockieren.

## Revendications

1. Procédé de fonctionnement d'un transistor de puissance bipolaire bidirectionnel qui a deux régions distinctes d'émetteur/collecteur de premier type de conductivité (622) sur des faces opposées d'un substrat massif de deuxième type de conductivité (610) d'une puce semi-conductrice, et deux régions distinctes de contact de base de second type de conductivité (632) sur les faces opposées du substrat massif (610), le procédé comprenant de :
1) dans une phase de synchronisation de transistor-activé, lorsqu'une chute de tension minimale est souhaitée, polariser une première des régions de contact de base (632), qui est la plus proche de celle des régions d'émetteur/collecteur (622) qui agit comme collecteur,
comme défini par une polarité de tension appliquée extérieurement, à une tension qui provoque une conduction bipolaire, pour ainsi réduire la chute de tension entre les deux régions d'émetteur/collecteur (622) ; puis
2) dans une première phase de synchronisation de pré-coupure, court-circuiter chacune des régions de contact de base (632) de la région respectivement la plus proche des régions d'émetteur/collecteur (622), pour ainsi augmenter la chute de tension entre les deux régions d'émetteur/collecteur (622) ; et ensuite **caractérisé par**
3) dans une seconde phase de synchronisation de pré-coupure, polariser la seconde région de contact de base (632) avec une polarité opposée à celle appliquée à la première région de contact de base (632) à l'étape 1), pour ainsi réduire la concentration de porteurs minoritaires dans le substrat massif (610).

2. Procédé selon la revendication 1, comprenant en outre, avant l'étape 1) de :
0) dans une phase de synchronisation de diode-activée, court-circuiter la première des régions de contact de base (632) de sa région d'émetteur/collecteur (622) la plus proche, pour ainsi initier la conduction entre les deux régions d'émetteur/collecteur (622);
et comprenant en outre, après l'étape 3) de :
4) court-circuiter la seconde région de contact de base (632) de sa région d'émetteur/collecteur (622) la plus proche, pour maintenir le dispositif désactivé.

3. Procédé selon la revendication 1, comprenant en outre, après l'étape 3) de :
4) désactiver le dispositif.

4. Procédé selon la revendication 1, comprenant en outre de :
lors de l'étape 3), utiliser une diode pour bloquer le courant qui aurait tendance à activer la conduction dans un sens opposé à celui de l'étape 1).

5. Procédé selon l'une quelconque des revendications précédentes, dans lequel le premier type de conductivité est le type n.

6. Procédé selon l'une quelconque des revendications 1 à 4, dans lequel l'étape 3) a une durée plus courte que l'étape 2).

7. Procédé selon l'une quelconque des revendications 1 à 4, dans lequel la puce semi-conductrice est en silicium.

8. Circuit d'attaque de base qui est connecté à un transistor de puissance bipolaire bidirectionnel à double base,
dans lequel le transistor de puissance bipolaire bidirectionnel a deux régions distinctes d'émetteur/collecteur de premier type de conductivité (622) sur des faces opposées d'un substrat massif de deuxième type de conductivité (610) d'une puce semi-conductrice, et deux régions distinctes de contact de base de deuxième type de conductivité (632) sur les faces opposées du substrat massif (610) ;
dans lequel le circuit d'attaque de base comprend trois branches de circuit (S11, S12, S13; S21, S22, S23) connectées à chacune des deux régions de contact de base (632) du transistor de puissance bipolaire bidirectionnel, dans lequel une branche de circuit (S13; S23) peut fonctionner pour fournir une conduction bidirectionnelle, et les autres branches de circuit (S11; S21, S12; S22) peuvent fonctionner pour fournir des décalages de tension de différentes polarités;
et dans lequel le circuit d'attaque de base est configuré pour mettre en œuvre le procédé selon l'une quelconque des revendications 1 à 4.

9. Circuit d'attaque de base selon la revendication 8, qui comprend en outre une diode à barrière de Schottky qui est connectée pour bloquer l'activation de la conduction inverse pendant des périodes d'attaque de base négative.
